(19) Europäisches Patentamt
European Patent Office
Office européen des brevets

(11) **EP 4 565 040 A2**

(12) **EUROPEAN PATENT APPLICATION**

(43) Date of publication:
04.06.2025 Bulletin 2025/23

(21) Application number: 24216147.9

(22) Date of filing: 28.11.2024

(51) International Patent Classification (IPC):
*H10H 29/14* (2025.01)    *H10H 29/851* (2025.01)

(52) Cooperative Patent Classification (CPC):
H10H 29/14; H10H 29/8513

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority:  01.12.2023  US 202363605034 P
          19.08.2024  US 202463684503 P
          27.11.2024  US 202418963184

(71) Applicant: Seoul Semiconductor Co., Ltd.
Gyeonggi-do 15429 (KR)

(72) Inventors:
• JANG, BoRaml
  15429 Ansan-si (KR)
• KO, MiSo
  15429 Ansan-si (KR)
• CHOI, EunMi
  15429 Ansan-si (KR)

(74) Representative: Stolmár & Partner
Patentanwälte PartG mbB
Blumenstraße 17
80331 München (DE)

(54) **LIGHT EMITTING DEVICE**

(57)    A light emitting device including light emitting elements emitting light within a predetermined color temperature region on a color coordinate system. An average of color coordinate values of the plurality of light emitting elements are located within the predetermined color temperature region, the plurality of light emitting elements include a first light emitting element and a second light emitting element that satisfy a predetermined equation comparing the emission of the light emitting elements with a natural light spectrum.

*FIG.14*

EP 4 565 040 A2

**Description**

**TECHNICAL FIELD**

The present disclosure relates to a light emitting device.

**BACKGROUND**

In general, lighting devices installed indoors are manufactured in various forms and shapes, and their configuration includes a main body, to be fixed to a ceiling or wall, etc., which has a light source that emits light and various parts related thereto, and a light-transmitting cover which is manufactured to maintain illumination and to form an attractive appearance.

Meanwhile, there is an increasing demand for technologies that can implement white light similar to natural light using light-emitting device.

**SUMMARY**

In view of the above, the embodiments of the present disclosure provide a light emitting device that generates light similar to natural light.

Further, the embodiments of the present disclosure provide a light emitting device with vivid color reproduction.

Further, the embodiments of the present disclosure achieve a high quality light emitting device with low chromatic aberration.

In accordance with an aspect of the present disclosure, there may be provided a light emitting device including: a plurality of light emitting elements that emit light within a predetermined color temperature region on a color coordinate system, wherein an average of color coordinate values of

the plurality of light emitting elements are located within the predetermined color temperature region, the plurality of light emitting elements include a first light emitting element and a second light emitting element that satisfy a following Equation 1:

(Equation 1)

$$Srms = \sqrt{\frac{1}{(b-a)} \sum_{k=a}^{b} \left(1 - \frac{L_c(x_k)}{ref_C(x_k)}\right)^2} < 0.9$$

where in the Equation 1, the "a" is a wavelength selected from a range of 200 nm or more and less than 500 nm, the "b" is a wavelength selected from a range of 500 nm or more and less than 900 nm, the "$L_C(x_k)$" is a normalized spectral radiant flux of a light emitted from the plurality of light emitting elements, and the "$ref_c(x_k)$" is a normalized spectral radiant flux of a natural light normalized from a natural light spectrum. The color coordinate system may be the CIE 1931 color space.

Further, there may be provided the light emitting device in which the color temperature region has four vertices defined by a first coordinate, a second coordinate, a third coordinate, and a fourth coordinate on the color coordinate system, wherein the first coordinate has an x-value smaller than x-values of the second coordinate and the third coordinate, and a y-value smaller than y-values of the second coordinate, the third coordinate, and the fourth coordinate, wherein the second coordinate has a y-value smaller than the y-values of the third coordinate and the fourth coordinate, wherein the third coordinate has a y-value greater than the y-values of the first coordinate, the second coordinate, and the fourth coordinate, and an x-value greater than the first coordinate and the fourth coordinate, and wherein the fourth coordinate has a y-value greater than the y-values of the first coordinate and the second coordinate and smaller than the y-value of the third coordinate, and an x-value smaller than the x-values of the second coordinate and the third coordinate.

Further, there may be provided the light emitting device in which the color temperature region has an elliptical shape on the color coordinate system.

Further, there may be provided the light emitting device in which the color temperature region is inclined at a predetermined angle with respect to an x-axis on the color coordinate system.

Further, there may be provided the light emitting device in which the predetermined angle ranges from 40° to 70°.

Further, there may be provided the light emitting device in which a length of a major axis of the color temperature region ranges from 0.0110 to 0.0144.

Further, there may be provided the light emitting device in which a length of the minor axis of the color temperature region ranges from 0.0045 to 0.0066.

Further, there may be provided the light emitting device in which the color temperature of the light emitted by the plurality of light emitting elements ranges from 1700K to 7000K.

Further, there may be provided a light emitting device including: a plurality of first light emitting elements that emit light in a first color temperature region on a color coordinate system among a plurality of color temperature regions; a plurality of second light emitting elements that emit light in a second color temperature region, different from the first color temperature region, on the color coordinate system; and a controller that controls an intensity of light emitted from the plurality of light emitting elements such that an average of color coordinate values of the plurality of first light emitting elements and the second light emitting elements are positioned within one of the plurality of color temperature regions, wherein the controller controls the plurality of first light emitting element and the second light emitting element to satisfy a following equation 1:

(Equation 1)

$$Srms = \sqrt{\frac{1}{(b-a)} \sum_{k=a}^{b} \left(1 - \frac{L_c(x_k)}{ref_c(x_k)}\right)^2} < 0.9$$

where in the Equation 1, the "a" is a wavelength selected from a range of 200 nm or more and less than 500 nm, the "b" is a wavelength selected from a range of 500 nm or more and less than 900 nm, the "$L_C(x_k)$" is a normalized spectral radiant flux of a light emitted from the plurality of light emitting elements, and the "$ref_c(x_k)$" is a normalized spectral radiant flux of a natural light normalized from a natural light spectrum.

Further, there may be provided the light emitting device in which the first color temperature region has the largest central color coordinate x- and y-values among the plurality of color temperature regions, and the second color temperature region has the smallest central color coordinate x- and y-values among the plurality of color temperature regions, and the controller controls the intensity of light emitted from the plurality of first light emitting elements and the intensity of light emitted from the second light emitting elements such that the average of the color coordinate values of the plurality of light emitting elements moves from one of the first color temperature region and the second color temperature region toward the other of the first color temperature region and the second color temperature region.

Further, there may be provided the light emitting device in which the controller increases the intensity of light emitted from the plurality of first light emitting elements and decreases the intensity of light emitted from the plurality of second light emitting elements so that the average of the color coordinate values of the plurality of light emitting elements to move towards the first color temperature region.

Further, there may be provided the light emitting device in which the controller decreases the intensity of light emitted from the plurality of first light emitting elements and increases the intensity of light emitted from the plurality of second light emitting elements so that the average of the color coordinate values of the plurality of light emitting elements to move towards the second color temperature region.

Further, there may be provided the light emitting device in which the controller controls the intensity of light emitted from the plurality of first light emitting elements and the intensity of light emitted from the plurality of second light emitting elements to be equal so that the average of the color coordinate values of the plurality of light emitting elements is disposed in a center of the first color temperature region and the second color temperature region while being disposed within one of the plurality of color temperature regions.

Further, there may be provided the light emitting device in which the plurality of color temperature regions have rectangular shapes on the color coordinate system and at least some of which are in contact with each other.

Further, there may be provided the light emitting device in which a size of the first color temperature region is larger than a size of the second color temperature region.

Further, there may be provided the light emitting device in which the plurality of color temperature regions have elliptical shapes on the color coordinate system and are arranged to be spaced apart from each other.

Further, there may be provided the light emitting device in which the plurality of color temperature regions are arranged at a predetermined angle with respect to an x-axis of the color coordinate system.

Further, there may be provided the light emitting device in which an angle at which the first color temperature region is inclined is different from an angle at which the second color temperature region is inclined.

In accordance with one aspect of the present disclosure, there may be provided a light emitting device including: a light emitter for generating light; and a controller for controlling the light emitter to satisfy a Srms defined in a following Equation 1 is within the range of 0.001 to 0.9,

(Equation 1)

$$Srms = \sqrt{\frac{1}{(b-a)}\sum_{k=a}^{b}\left(1 - \frac{L_c(x_k)}{ref_C(x_k)}\right)^2} < 0.9$$

where in the Equation 1, the "a" is a wavelength selected from a range of 200 nm or more and less than 500 nm, the "b" is a wavelength selected from a range of 500 nm or more and less than 900 nm, the "$L_C(x_k)$" is a normalized spectral radiant flux of a light emitted from the light emitter, and the "$ref_c(x_k)$" is a normalized spectral radiant flux of a natural light normalized from a natural light spectrum.

Further, there may be provided the light emitting device in which the light emitter includes: a first light emitting element for generating light within a first color temperature region among a plurality of color temperature regions on a color coordinate system; and a second light emitting element for generating light within a second color temperature region that is different from the first color temperature region among the plurality of color temperature regions, and the controller stores light intensity data for adjusting an intensity of light from the first light emitting element and an intensity of light from the second light emitting element.

According to the embodiments of the present disclosure, the light emitting device can generate light similar to natural light. Further, it is possible to provide the light emitting with vivid color reproduction. In addition, it is possible to achieve a high quality light emitting device with low chromatic aberration.

## BRIEF DESCRIPTION OF THE DRAWINGS

Fig. 1 is an exploded perspective view of a light emitting device according to a first embodiment of the present disclosure.
Fig. 2 shows a light emitter of the light emitting device in Fig. 2.
Fig. 3 is a plan view of the light emitter of the light emitting device in Fig. 3.
Fig. 4 illustrates a first example of a plurality of color temperature regions where the average chromaticity values of a plurality of first light emitting elements and a plurality of second light emitting elements of the light emitting device in Fig. 2 can be located.
Fig. 5 shows a second example of a plurality of color temperature regions where the average chromaticity values of a plurality of first light emitting elements and a plurality of second light emitting elements of the light emitting device in Fig. 2 can be located.
Fig. 6 illustrates a third example of a plurality of color temperature regions where the average chromaticity values of a plurality of first light emitting elements and a plurality of second light emitting elements of the light emitting device in Fig. 2 can be located.
Fig. 7 is a comparison diagram of the sizes of the color temperature regions.
Fig. 8 shows a diagram showing the similarity to natural light when the light emitter or light emitting device according to the second embodiment of the present disclosure emits light with correlated color temperatures of 6500K and 2700K.
FIG. 9 is a diagram showing a relative spectral flux of natural light at a correlated color temperature of 6500K.
FIG. 10 is a diagram showing a relative spectral flux of natural light at a correlated color temperature of 5000K.
FIG. 11 is a diagram showing a relative spectral flux of natural light at a correlated color temperature of 4000K.
FIG. 12 is a diagram showing a relative spectral flux of natural light at a correlated color temperature of 3000K.
FIG. 13 is a diagram showing a relative spectral flux of natural light at a correlated color temperature of 2700K.
FIG. 14 is an example of a color coordinate shift for mixed light of the first light emitting element and the second light emitting element when the first light emitting element of the light emitting device of the present disclosure has a lower color temperature than the second light emitting element.
Fig. 15 shows an example of natural light similarity of mixed light from the first light emitting element with a high color temperature and the second light emitting element with a low color temperature.
Fig. 16 is a graph showing an intensity of light from the first light emitting element and the second light emitting element in color temperature correlation information.

## DETAILED DESCRIPTION

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a light emitting device 1 according to a first embodiment of the present disclosure will be described with reference to the drawings.

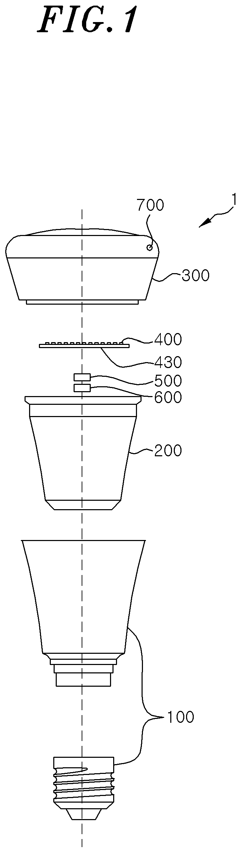

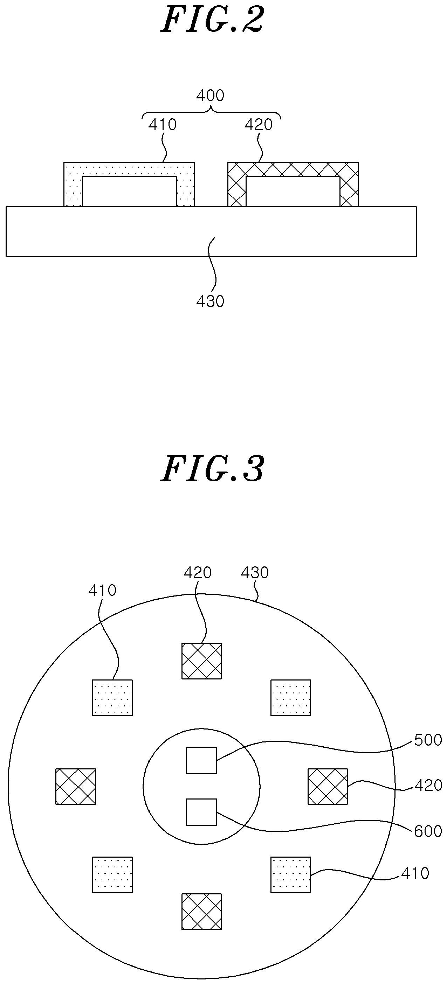

Referring to Figs. 1 to 3, the light emitting device according to the first embodiment of the present disclosure is a device that can generate light. The light emitting device can be installed indoors, but is not limited to that. It can be controlled by a switch provided on the wall of an indoor space to generate light or can be controlled by a terminal to emit light.

Additionally, a correlated color temperature of the light generated by the light emitting device can be formed to be similar to that of natural light. Natural light is a light emitted from the sun toward a space where the light emitting device is installed, and it can vary depending on time and weather. In other words, the light emitting device can generate light with the correlated color temperature that changes with time and weather, but is not limited thereto.

The light emitting device 1 may include a housing 100, a heat sink 200, a cover 300, a light emitter 400, a power distributor 500, and a controller 600, and may further include a microphone 700.

The housing 100 can accommodate the heat sink 200, light emitter 400, and controller 600. The housing 100 may have an opening formed on one side to accommodate the heat sink 200, the light emitter 400, and the controller 600 therein. The housing 100 may form an exterior of the light emitting device 1. For example, the housing 100 may be formed in the form of a light bulb such as a bulb, ball, or Edison, or a socket type such as a krypton or candlestick type, or various lighting shapes such as an EL type, PAR type, or downlight, as well as various structures such as automobile headlamps, rear lights for automobile, and flashes for mobile phones.

The heat sink 200 may be provided in an interior of the housing 100 to dissipate heat from the interior of the housing 100. In other words, the heat sink 200 can dissipate heat from the light emitter 400 and the controller 600. The heat sink 200 may be constructed of a material such as aluminum, copper, iron, or the like having a high thermal conductivity, and may be constructed of a material having a thermal conductivity of 100 W/mK or more. More preferably, it may have a thermal conductivity of 200 W/mK or greater, but is not limited thereto.

The cover 300 may be removably coupled to the housing 100 to cover an opening in the housing 100. Further, the cover 300 may be formed to transmit light generated by the light emitter 400, and preferably a material having a transmittance of 80% or greater may be used. The cover 300 may be composed of a glass material such as soda-lime glass, borosilicate glass, borosilicate, or the like, and may be composed of PP, PC, PMMA, acrylic resin, or the like. In addition, the cover 300 may be coated with additives such as silica ($SiO_2$), titanium dioxide ($TiO_2$), alumina ($Al_2O_3$), barium sulfate ($BaSO_4$), and the like to disperse or diffuse to increase color uniformity when light from the light emitter 400 is transmitted. The cover 300 may also be designed in shapes like Fresnel or uneven textures to improve color uniformity.

The light emitter 400 may be consist of one or more light emitting elements that can generate light. The light emitter 400 may include a plurality of a first light emitting elements 410, a plurality of second light emitting elements 420, and a substrate 430. Additionally, the light emitter 400 may have a wavelength converter. The wavelength converter can include any of a resin with phosphors, QD, or the like. For example, $(Ba, Sr, Ca)_2SiO_4:Eu^{2+}$, YAG $((Y, Gd)_3(Al, Ga)_5O_{12}:Ce^{3+})$ series phosphors, TAG $((Tb, Gd)_3(Al, Ga)_5O_{12}:Ce^{3+})$ series phosphors, $(Ba, Sr, Ca)_3SiO_5: Eu^{2+}$, $(Ba, Sr, Ca)MgSi_2O_6:Eu^{2+}, Mn^{2+}$, $(Ba, Sr, Ca)_3MgSi_2O_8: Eu^{2+}, Mn^{2+}$, and $(Ba, Sr, Ca)MgSiO_4:Eu^{2+}, Mn^{2+}$, or a fluoride-based phosphor represented by $A_2MF_6:Mn^{4+}$, where A may be Li, Na, K, Ba, Rb, Cs, Mg, Ca, Se or Zn, and M may be at least one species selected from the group consisting of Ti, Si, Zr, Sn, or Ge.

The light emitter 400 may include two or more first light emitting elements 410 and second light emitting elements 420 having different correlated color temperatures (CCT) as light emitting elements. The light emitter 400 may generate light between the correlated color temperatures of the plurality of first light emitting elements 410 and second light emitting elements 420 by combining the plurality of first light emitting elements 410 and second light emitting elements 420. For example, the light emitter 400, which includes at least one of a plurality of first emitting elements 410 that emits light with a correlated color temperature of 1700K or more and at least one of a plurality of second light emitting elements 420 that emits light with a correlated color temperature of 7000K or less, may emit light with a correlated color temperature between 1700K and 7000K.

In other words, the light emitter 400 including the plurality of first light emitting elements 410 and the plurality of second light emitting elements 420 can have a correlated color temperature equal to or higher than an average of the correlated color temperatures of the plurality of first light emitting elements 410 and a correlated color temperature equal to or lower than an average of the plurality of second light emitting elements 420.

Further, the light emitter 400 may include light emitting elements having spectra (correlated color temperatures) of two or more different wavelengths, which may have different peak wavelengths, to represent different colors. The light emitter 400 can control the operation of the light emitting elements having two or more different peak wavelengths to generate light having various CIE color coordinates. For example, the first light emitting element 410 may emit light including red light with a peak wavelength of 600 nm and 750 nm, the second light emitting element 420 may emit light including blue light with a peak wavelength of 400 nm and 490 nm, and the light emitter 400 may emit light between blue and red.

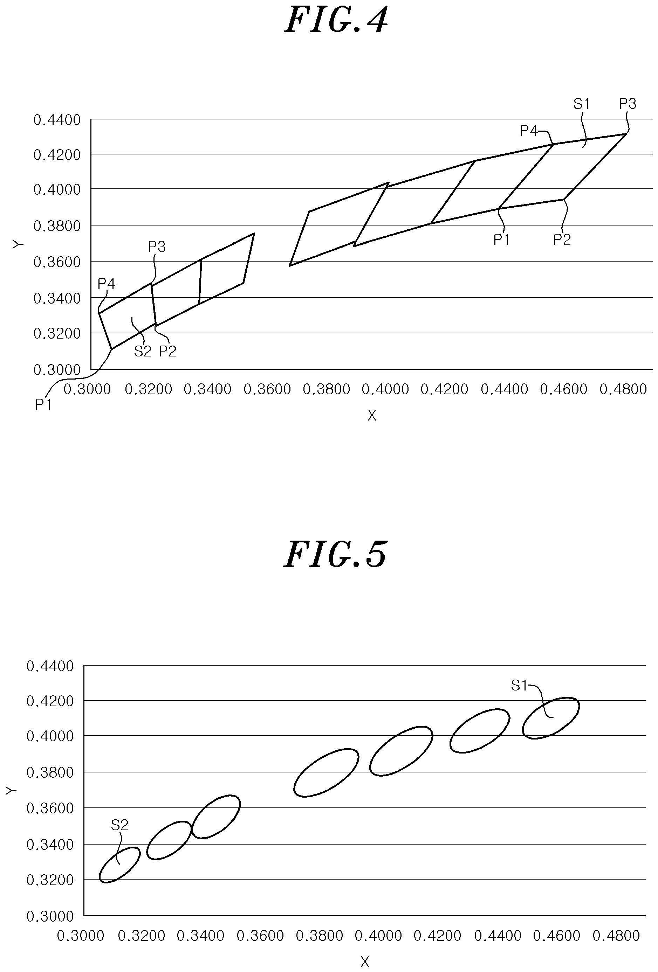

Referring further to Figs. 4 to 7, the plurality of first light emitting elements 410 and the second light emitting elements 420 may generate light within a predetermined color temperature region in a color coordinate system. The average of color coordinate values of the plurality of first light emitting elements 410 and second light emitting elements 420 may be located within the color temperature region. In this case, the color coordinates may occupy a specific area within the CIE 1931 coordinates. The color temperature region may be formed in a plurality. In other words, the average of the color coordinate values of the plurality of first light emitting elements 410 and second light emitting elements 420 may be located within any one of the plurality of color temperature regions. The plurality of color temperature regions may be arranged in a direction of the x-axis on the color coordinate system, such that as the x-value of the central color coordinate values increases, the y-value also increases. Further, the plurality of color temperature regions may include a first color temperature region S1 and a second color temperature region S2.

The first color temperature region S1 may be the region with the largest central color coordinate x- and y-values among the plurality of color temperature regions. The plurality of first light emitting elements 410 may generate light within first color temperature region S1 in the color coordinate system. In other words, as the light intensity of the plurality of first light emitting elements 410 is increased and the light intensity of the plurality of second light emitting elements 420 is decreased, the average color coordinate values of the light emitter 400 may move towards the first color temperature region S1 in the direction where the color temperature regions of the first light emitting elements 410 are arranged.

The second color temperature region S2 may be the region with the smallest central color coordinate x- and y-values among the plurality of color temperature regions. The plurality of second light emitting elements 420 may generate light within the second color temperature region S2 in the color coordinate system. In other words, as the light intensity of the plurality of second light emitting elements 420 is increased and the light intensity of the plurality of first light emitting elements 410 is decreased, the average of the color coordinate values of the light emitter 400 may move towards the second color temperature region S2 in the direction where the color temperature ranges of the second light emitting elements 420 are arranged. Furthermore, the plurality of color temperature regions may be formed in various shapes.

Referring to Fig. 4, as a first example, the plurality of color temperature ranges may have a rectangular shape on the color coordinate system. The color temperature range may have a plurality of vertices with a first coordinate P1, a second coordinate P2, a third coordinate P3, and a fourth coordinate P4.

The first coordinate P1 may have an x value that is smaller than the x values of the second coordinate P2 and the third coordinate P3, and a y value that is smaller than the y values of the second coordinate P2, the third coordinate P3, and the fourth coordinate P4, but is not limited thereto. In other words, the x value of the first coordinate P1 of the first color temperature region S1 may be smaller than the x values of the second coordinate P2, the third coordinate P3, and the fourth coordinate P4. The y value of the first coordinate P1 of the first color temperature region S1 may be smaller than the y values of the second coordinate P2, the third coordinate P3, and the fourth coordinate P4. For example, the x-value of the first coordinate P1 within the first color temperature region S1 may be approximately 0.4373, and the y-value may be approximately 0.3893. Additionally, the x-value of the second coordinate P2 may be approximately 0.4593, and the y-value may be approximately 0.3944. The x-value of the third coordinate P3 may be approximately 0.4813, and the y-value may be approximately 0.4319. The x-value of the fourth coordinate P4 may be approximately 0.45623, and the y-value may be approximately 0.4260. However, these values are not limited to the above examples. Furthermore, when multiple first light-emitting elements 410 have color coordinates within the first color temperature region S1, the first light-emitting elements 410 may have an rms value of similarity to natural light (Srms) that is less than 0.9, as will be described later. Through this, the first light-emitting elements 410 may have a spectrum similar to that of sunlight. Further, the x value of the first coordinate P1 of the second color temperature region S2 may be located between the x value of the fourth coordinate P4 and the x value of the second coordinate P2. The y value of the first coordinate P1 of the second color temperature region S2 may be less than the y values of the second coordinate P2, the third coordinate P3, and the fourth coordinate P4. For example, the x-value of the first coordinate P1 within the second color temperature region S2 may be approximately 0.3067, and the y-value may be approximately 0.3119. Additionally, the x-value of the second coordinate P2 may be approximately 0.3221, and the y-value may be approximately 0.3255. The x-value of the third coordinate P3 may be approximately 0.3205, and the y-value may be approximately 0.3477. The x-value of the fourth coordinate P4 may be approximately 0.3026, and the y-value may be approximately 0.3311. However, these values are not limited to the above examples. Furthermore, when multiple second light-emitting elements 420 have color coordinates within the second color temperature region S2, the second light-emitting elements 420 may have an rms value of similarity to natural light (Srms) that is less than 0.9, as will be described later. Through this, the second light-emitting elements 420 may have a spectrum similar to that of sunlight. And the x value of the first coordinate P1 of the first color temperature region S1 may be greater than the x value of the first coordinate P1 of the second color temperature region S2. The first light-emitting elements 410, having color coordinates in the first color temperature region S1, may have a higher intensity in the red region compared to the second light-emitting elements 420, which has color coordinates in the second color temperature region S2. Through this, the intensity in the red region of the mixed light from the first light emitting elements 410 and the second light emitting elements 420 may be compensated, thereby improving the natural light similarity rms (Srms) value in the red light region Furthermore, the y value of the first coordinate P1 of the first color temperature region S1 may be greater than the y value of the first coordinate P1 of the second color temperature region S2. The first light-emitting elements 410, having color coordinates in the first color temperature region S1, may have a higher intensity in the green region compared to the second light-emitting elements 420, which has color coordinates in the second color temperature region S2. Through this, the intensity in the green region of the mixed light from the first light emitting elements 410 and the second light emitting elements 420 may be compensated, thereby improving the natural light similarity rms (Srms) value in the green light region

The second coordinate P2 may have a y value smaller than the y values of the third coordinate P3 and the fourth coordinate P4, and may have an x value greater than the x value of the fourth coordinate P4. In other words, the x value of the second coordinate P2 of the first color temperature region S1 may be smaller than the x value of the third coordinate P3 and larger than the x values of the fourth coordinate P4 and the first coordinate P1. The y value of the second coordinate P2 of the first color temperature region S1 may be smaller than the y values of the third coordinate P3 and the fourth coordinate P4, and larger than the y value of the first coordinate P1. Additionally, the x value of the second coordinate P2 of the second color temperature region S2 may be greater than the x values of the first coordinate P1, the third coordinate P3, and the fourth coordinate P4. The y value of the second coordinate P2 of the second color temperature region S2 may be smaller than the y values of the third coordinate P3 and the fourth coordinate P4, and larger than the y value of the first coordinate P1. The x value of the second coordinate P2 of the first color temperature region S1 may be greater than the x value of the second coordinate P2 of the second color temperature region S2. The first light-emitting elements 410, having color coordinates in the first color temperature region S1, may have a higher intensity in the red region compared to the second light-emitting elements 420, which has color coordinates in the second color temperature region S2. Through this, the intensity in the red region of the mixed light from the first light emitting elements 410 and the second light emitting elements 420 may be compensated, thereby improving the natural light similarity rms (Srms) value in the red light region. Furthermore, the y value of the second coordinate P2 of the first color temperature region S1 may be greater than the y value of the second coordinate P2 of the second color temperature region S2. The first light-emitting elements 410, having color coordinates in the first color temperature region S1, may have a higher intensity in the green region compared to the second light-emitting elements 420, which has color coordinates in the second color temperature region S2. Through this, the intensity in the green region of the mixed light from the first light emitting elements 410 and the second light emitting elements 420 may be compensated, thereby improving the natural light similarity rms (Srms) value in the green light region.

The third coordinate P3 may have a y value greater than the y values of the first coordinate P1, the second coordinate P2, and the fourth coordinate P4. Further, the third coordinate P3 may have an x value greater than the x values of the first coordinate P1 and the fourth coordinate P4. In other words, the x value of the third coordinate P3 of the first color temperature region S1 may be greater than the x values of the first coordinate P1, the third coordinate P3, and the fourth coordinate P4. The y value of the third coordinate P3 of the first color temperature region S1 may be greater than the y values of the first coordinate P1, the second coordinate P2, and the fourth coordinate P4. Additionally, the x value of the third coordinate P3 of the second color temperature region S2 may be greater than the x values of the first coordinate P1 and the fourth coordinate P4, and smaller than the x value of the third coordinate P3. The y value of the third coordinate P3 of the second color temperature region S2 may be greater than the y values of the first coordinate P1, the second coordinate P2, and the fourth coordinate P4. The x value of the third coordinate P3 of the first color temperature region S1 may be greater than the x value of the third coordinate P3 of the second color temperature region S2. The first light-emitting elements 410, having color coordinates in the first color temperature region S1, may have a higher intensity in the red region compared to the second light-emitting elements 420, which has color coordinates in the second color temperature region S2. Through this, the intensity in the red region of the mixed light from the first light emitting elements 410 and the second light emitting elements 420 may be compensated, thereby improving the natural light similarity rms (Srms) value in the red light region. Furthermore, the y value of the third coordinate P3 of the first color temperature region S1 may be greater than the y value of the third coordinate P3 of the second color temperature region S2. The first light-emitting elements 410, having color coordinates in the first color temperature region S1, may have a higher intensity in the green region compared to the second light-emitting elements 420, which has color coordinates in the second color temperature region S2. Through this, the intensity in the green region of the mixed light from the first light emitting elements 410 and the second light emitting elements 420 may be compensated, thereby improving the natural light similarity rms (Srms) value in the green light region.

The fourth coordinate P4 may have a y value greater than the y values of the first coordinate P1 and the second coordinate P2, but less than the y value of the third coordinate P3. Further, the fourth coordinate P4 may have an x value smaller than at least one of the x values of the first coordinate P1, the second coordinate P2, and the third coordinate P3. In other words, the x value of the fourth coordinate P4 of the first color temperature region S1 may be greater than the x value of the first coordinate P1 and smaller than the x values of the second coordinate P2 and the third coordinate P3. The y value of the fourth coordinate P4 of the first color temperature region S1 may be greater than the y values of the first coordinate P1 and the second coordinate P2, but smaller than the y value of the third coordinate P3. Further, the x value of the fourth coordinate P4 of the second color temperature region S2 may be smaller than the x values of the first coordinate P1, the second coordinate P2, and the third coordinate P3. The y value of the fourth coordinate P4 of the second color temperature region S2 may be greater than the y values of the first coordinate P1 and the second coordinate P2, but smaller than the y value of the third coordinate P3. The x value of the fourth coordinate P4 of the first color temperature region S1 may be greater than the x value of the fourth coordinate P4 of the second color temperature region S2. The first light-emitting elements 410, having color coordinates in the first color temperature region S1, may have a higher intensity in the red region compared to the second light-emitting elements 420, which has color coordinates in the second color temperature region S2. Through this, the intensity in the red region of the mixed light from the first light emitting elements 410 and the second light emitting elements 420 may be compensated, thereby improving the natural light similarity rms (Srms) value in the red light region. Furthermore, the y value of the fourth coordinate P4 of the first color temperature region S1 may be greater than the y value of the fourth coordinate P4 of the second color temperature region S2. The first light-emitting elements 410, having color coordinates in the first color temperature region S1, may have a higher intensity in the green region compared to the second light-emitting elements 420, which has color coordinates in the second color temperature region S2. Through this, the intensity in the green region of the mixed light from the first light emitting elements 410 and the second light emitting elements 420 may be compensated, thereby improving the natural light similarity rms (Srms) value in the green light region.

Further, at least some of the sizes of the plurality of color temperature ranges may be formed differently. In other words, the sizes of the plurality of color temperature ranges may increase towards the first color temperature region S1. The size of the first color temperature region S1 may be larger than that of the second color temperature region S2. The distance between the first coordinate P1 and the third coordinate P3 of the plurality of color temperature ranges may increase as it approaches the first color temperature region S1. In this manner, by widening the area of the first color temperature region S1, which has a relatively smaller gradient variation in the natural light spectrum, it may be possible to maintain the natural light similarity rms (Srms) value at 0.9 or below while reducing design complexity. Further, the plurality of color temperature ranges may be arranged such that at least some of them are adjacent to each other.

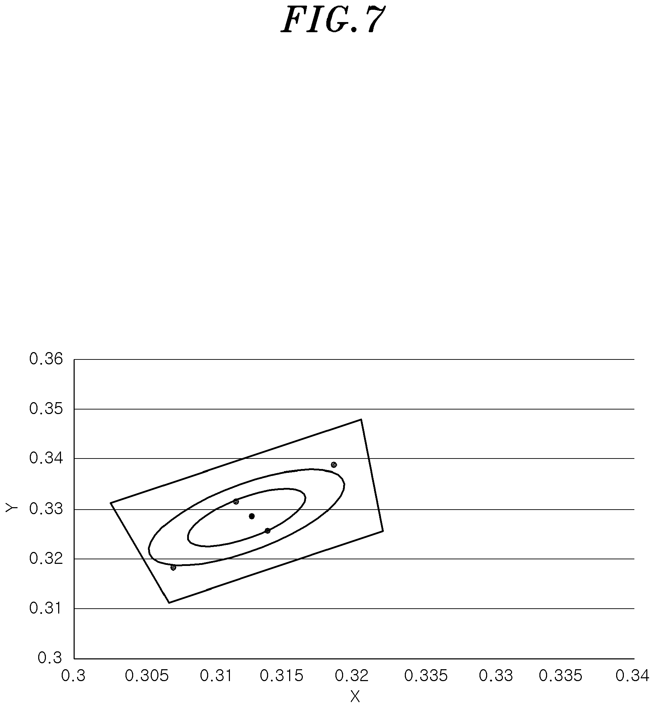

Referring to Fig. 5, as a second example, the plurality of color temperature ranges may have an elliptical shape on the color coordinate system. The light sources within one of these ellipses may have similar colors perceived by the average human eye, resulting in a light emitting device with low color difference. Lengths of major axes of the plurality of ellipses may range from 0.0110 to 0.0144, and lengths of minor axes may range from 0.0045 to 0.0066, but is not limited thereto. Referring to Fig. 7, the plurality of color temperature ranges in the second example may be formed smaller than those in the first example. The light sources within one of the plurality of ellipses may not only be perceived similarly by the average human eye, but may also be recognized as similar colors by sensitive individuals or when plurality of sources are placed adjacently, thus creating a premium light emitting device. The color temperature region of the second example may be positioned within each of the plurality of color temperature regions of the first example. The midpoint color coordinate values of the color temperature ranges in the second example may differ from those in the first example.

Further, the plurality of color temperature ranges of the second example may be tilted at a predetermined angle with respect to the x-axis of the color coordinate system. The predetermined angle may be range from 40° to 70°, but is not limited thereto. Further, the tilted angles of at least some of the plurality of color temperature regions may be formed differently. The tilted angle of the first color temperature region S1 may be formed differently from the tilted angle of the second color temperature region S2. In other words, the angle at which the first color temperature region S1 is tilted may be greater than the angle at which the second color temperature region S2 is tilted. The plurality of color temperature regions may be spaced apart from each other. Further, at least some of the plurality of color temperature regions may be formed with different sizes.

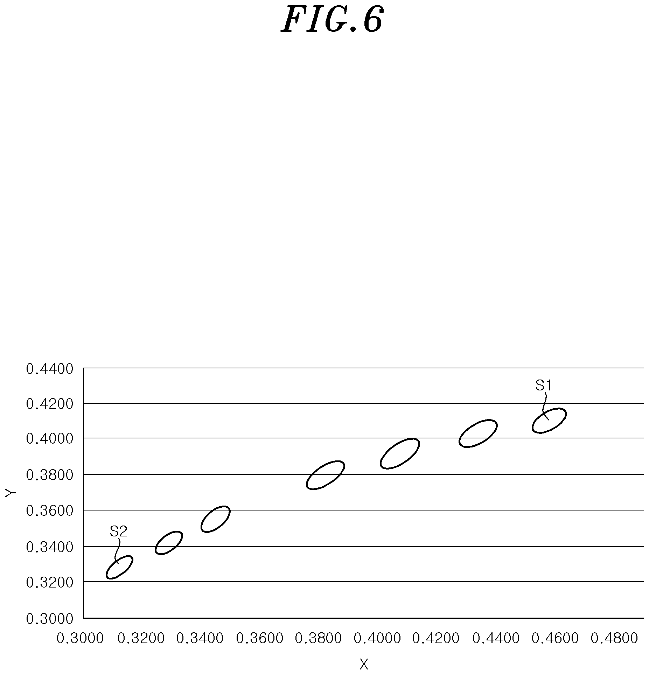

Referring to Figs. 6 and 7, as a third example, color temperature ranges may be formed as smaller ellipses compared to the color temperature ranges in the second example. In other words, the color temperature ranges in the third example may be located inside each of the color temperature ranges of the second example. The lengths of the major axes of the color temperature ranges may range from 0.0066 to 0.0086, while the lengths of the minor axes thereof may range from 0.0027 to 0.0040. This enables a high quality light emitting device with less chromatic aberration in the color temperature region of the third example than in the second example to be realized.

Additionally, the color temperature ranges in the third example may be tilted at a predetermined angle relative to the x axis of the color coordinate system. For instance, the predetermined angle may range from 40° to 70°. The tilt angle of the color temperature ranges in the third example may be the same as that of the second example. In other words, the tilt angle of the first color temperature region S1 may be greater than that of the second color temperature region S2. This is because the steeper the slope of the color temperature lines on the black body locus, the greater the tilt angle may be, allowing for the selection of regions with similar color temperatures and the implementation of high quality light emitting devices with reduced chromatic aberration. The plurality of color temperature regions may be spaced apart from each other. Further, at least some of the sizes of the plurality of color temperature regions may be formed differently.

The substrate 430 may support the plurality of first light emitting elements 410 and second light emitting elements 420. The substrate 430 may be made of alumina, quartz, calcium zirconate, forsterite, SiC, graphite, fused silica, mullite, cordierite, zirconia, beryllia, aluminum nitride, low-temperature co-fired ceramic (LTCC), paper phenolic, or epoxy resin combined with glass or paper. It may also be made by adding a wiring section composed of metals and metal compounds such as Cu, Al, Ag, Au, Ni, W, or the like on an insulating layer made of polyimide (P.I), bismaleimide/triazine (B.T), Teflon, PMMA, or polycarbonate (PC). The substrate 430 may be a printed circuit board (PCB) that includes metal wiring.

The power distributor 500 may apply power input from an outside to at least one of the first light emitting element 410 and the second light emitting element 420. In addition, the power distributor 500 may adjust the power applied to the first light emitting element 410 and the power applied to the second light emitting element 420. The intensity of light of the first light emitting element 410 and the second light emitting element 420 can be varied by the power distributor 500, and through this, the correlated color temperature can be adjusted. Additionally, the power distributor 500 can adjust the intensity of light from the first light-emitting element 410 and the second light-emitting element 420 to tune the mixed light's natural light similarity rms (Srms) to a value smaller than 0.9. This enables the implementation of a light-emitting device 1 that emits light similar to natural light.

For example, if the power applied to the first light emitting element 410 increases due to the power distributor 500, the intensity of light from the first light emitting element 410 may increase, while the power applied to the second light emitting element 420 may decrease, resulting in a reduction in the intensity of light from the second light emitting element 420. In this case, the correlated color temperature of the light emitter 400 may be closer to the first light emitting element 410 than to the second light emitting element 420, and may have a correlated color temperature that is relatively distant from that of the second light emitting element 420. Furthermore, the average color coordinate values of the first light emitting element 410 and the second light emitting element 420 may be positioned within the first color temperature region S1 or closer to the first color temperature region S1 than to the second color temperature region S2.

In another example, if the power applied to the first light emitting element 410 decreases due to the power distributor 500, the intensity of light from the first light emitting element 410 may reduce, while the power applied to the second light emitting element 420 increases, resulting in an increase in the intensity of light from the second light emitting element 420. In this case, the correlated color temperature of the light emitter 400 may be closer to the second light emitting element 420 than to the first light emitting element 410, and may have a correlated color temperature that is relatively distant from that of the first light emitting element 410. Further, the average color coordinate values of the first light emitting element 410 and the second light emitting element 420 may then be positioned within the second color temperature region S2 or closer to the second color temperature region S2 than to the first color temperature region S1.

Further, when the power distributor 500 adjusts the power applied to the first light emitting element 410 and the second light emitting element 420 to equalize the light amount of the first light emitting element 410 and the light amount of the second light emitting element 420, the light emitter 400 may have a correlated color temperature between the first light emitting element 410 and the second light emitting element 420. More preferably, if the light amount of the first light emitting element 410 and the light amount of the second light emitting element 420 are the same, the light emitter 400 that emits 3900K may have a correlated color temperature of 3900K to 4500K. Further, the average of the color coordinate values of the first light emitting element 410 and the second light emitting element 420 may be located between or in the center of the first color temperature region S1 and the second color temperature region S2.

Alternatively, the power distributor 500 may control the power amount of the first light emitting element 410 and the second light emitting element 420 by adjusting a time period during which power is supplied. The time period during which power is supplied may be adjusted by increasing or decreasing the duty cycle during which power is applied. That is, when the duty cycle increases, the amount of power increases and the light amount of the first light emitting element 410 and the second light emitting element 420 increases, and when the duty cycle decreases, the amount of power decreases and the light amount of the first light emitting element 410 and the second light emitting element 420 decreases. The intensity of light of the first light emitting element 410 and the second light emitting element 420 may be varied by the power distributor 500. For example, as the duty cycle applied to the first light emitting element 410 increases, the intensity of light of the first light emitting element 410 increases, and the duty cycle applied to the second light emitting element 420 decreases to reduce the amount of power, so that the intensity of light of the second light emitting element 420 may be reduced, and the light emitter 400 may have a correlated color temperature closer to that of the first light emitting element 410 than that of the second light emitting element 420. As another example, as the duty cycle applied to the first light emitting element 410 decreases, the amount of power decreases to decrease the intensity of light from the first light emitting element 410, and the duty cycle applied to the second light emitting element 420 increases to increase the power amount, so that the intensity of light of the second light emitting element 420 may increase, and the light emitter 400 may have a correlated color temperature closer to that of the second light emitting element 420 than that of the first light emitting element 410, and may have a correlated color temperature that is relatively distant from that of the first light emitting element 410. In addition, by adjusting the duty cycle applied to the first light emitting element 410 and the second light emitting element 420 to make the light amount of the first light emitting element 410 and the light amount of the second light emitting element 420 the same, the light emitter 400 may have a correlated color temperature between the first light emitting element 410 and the second light emitting element 420, and more preferably a correlated color temperature of 3900K to 4500K.

The controller 600 may control one or more of the light emitter 400 and the power distributor 500 to generate light from the light emitter 400. The controller 600 may adjust the intensity of light from the plurality of first light emitting elements 410 and the plurality of second light emitting elements 420 so that the average color coordinate values of the plurality of first light emitting elements 410 and the plurality of second light emitting elements 420 are located within any one of the plurality of color temperature regions. In other words, the controller 600 may control the power distributor 500 to adjust the intensity of light from the plurality of first light emitting elements 410 and second light emitting elements 420.

Further, the controller 600 may control the intensities of the plurality of first light emitting elements 410 and the plurality of second light emitting elements 420 so that the average of color coordinate values of the plurality of light emitting elements move from one of the first color temperature region S1 and the second color temperature region S2 towards the other of the first color temperature region S1 and the second color temperature region S2. Further, the controller 600 may increase the light intensity of the plurality of first light emitting elements 410 and decrease the light intensity of the plurality of second light emitting elements 420 such that the average of the color coordinate values of the plurality of first light emitting elements 410 and second light emitting elements 420 is moved toward the first color temperature region S1. The controller 600 may decrease the light intensity of the plurality of first light emitting elements 410 and increase the light intensity of the plurality of second light emitting elements 420 such that the average of the color coordinate values of the plurality of first light emitting elements 410 and second light emitting elements 420 moves toward the second color temperature region S2.

Furthermore, the controller 600 may equalize the intensities of light from the plurality of first light emitting elements 410 and the plurality of second light emitting elements 420, placing the average color coordinate values of the plurality of light-emitting elements at the center between the first color temperature region S1 and the second color temperature region S2.

The controller 600 may form the light intensity of the plurality of first light emitting elements 410 and the light intensity of the plurality of second light emitting elements420 to be the same such that the average of the color coordinate values of the plurality of first light emitting elements 410 and second light emitting elements 420 is disposed in one of the plurality of color temperature regions and is centered in the first color temperature region S1 and the second color temperature region S2.

A microphone 700 may be additionally arranged. The microphone 700 may receive sounds occurring in the space where the light emitting device 1 is installed. For example, sounds inputted through the microphone 700 may include various sounds such as movie audio or music. Based on the input from the microphone 700, the controller 600 may control the light emitter 400 to adjust the correlated color temperature of the light emitter 400. In other words, the controller 600 may adjust the color temperature of the light emitter 400 based on the volume of the sound inputted through the microphone 700. For example, the light emitter 400 may be controlled by the controller 600 such that when the sound volume increases, the correlated color temperature of the light emitter 400 increases, and when the sound volume decreases, the correlated color temperature of the light emitter 400 decreases.

Hereinafter, a light emitting device 1 according to a second embodiment of the present disclosure will be described. In describing the second embodiment, there is a difference that the controller 600 controls the light emitter 400 such that the natural light similarity rms (Srms) satisfies a ranging from 0.001 to 0.9, and this difference will be explained in detail.

The light emitter 400 and the light emitting device 1 may have spectral flux similar to natural light. The light emitter 400, which has the spectral flux similar to natural light, may be configured so that the Srms for the similarity to natural light according to wavelength in Equation 1 satisfies a range of 0.001 to 0.9. Here, the Srms refers to the natural light similarity rms. The natural light similarity rms (Srms) may be close to 0, indicating a high similarity to natural light. When the natural light similarity rms (Srms) exceeds 0.9, the similarity to the natural light spectrum may decrease, leading to lower color rendering and a decline in light quality. However, when Srms drops below 0.001, the design complexity may increase significantly beyond what users can perceive.

(Equation 1)

$$Srms = \sqrt{\frac{1}{(b-a)} \sum_{k=a}^{b} \left(1 - \frac{L1(x_k)}{ref(x_k)}\right)^2}$$

In Equation 1, a is a wavelength selected within the range of 200 nm or more and less than 500 nm, and b is a wavelength selected within the range of 500 nm or more and less than 900 nm. $L_c(x_k)$ is the normalized spectral radiant flux of the light emitted from the light emitter 400. $ref_c(x_k)$ is the normalized spectral radiant flux of natural light from the natural light spectrum.

The normalized spectral radiant flux of natural light may be obtained based on the highest radiant flux value in the natural light spectrum.

The normalized spectral radiant flux, that is, $L1(x_k)$ of the emitted light may be obtained by normalizing the spectral radiant flux such that a normalized luminous flux of the natural light obtained by multiplying the spectral radiant flux of the natural light normalized from the spectrum of the light emitter light emitter 400 by an area multiplied by a weighting factor $B(x_k)$, which accounts for human visual sensitivity, is equal to the area obtained by multiplying the spectral radiant flux of the light emitter 400 by an area multiplied by the weighting factor which accounts for human visual sensitivity. In other words, the luminous flux of $ref_c(x_k)$ and the luminous flux of $L_c(x_k)$ are normalized to have the same value.

That is, when the wavelength based spectrum for human visual sensitivity is denoted as $B(x_k)$, the normalized spectral radiant flux $L_c(x_k)$ of the emitted light and the normalized spectral radiant flux $ref_c(x_k)$ of natural light satisfy the following equation.

(Equation 2)

$$\int_a^b L_C(x_k)B(x_k)\partial x_k = \int_a^b ref_C(x_k)B(x_k)\partial x_k$$

The expression($1 - \frac{Lc(x_k)}{refc(x_k)}$) in Equation 1 represents the natural light similarity 5 ($x_k$) according to the wavelength. In this case, the closer the similarity value to nature at each wavelength is to zero, the more similar the light emitted from the light emitting device 1 or light emitter 400 is to natural light in the corresponding wavelength region.

To enhance the natural light similarity rms (Srms), the light emitter 400 may include at least one light-emitting element with a peak wavelength. This peak wavelength may be within the blue wavelength range of 400 nm to 480 nm. By increasing the intensity of the blue region, it is possible to improve the natural light similarity rms (Srms) in the blue light region. Additionally, to further enhance the natural light similarity in the blue region, the light emitter may include at least two light emitting elements with different peaks. In this case, the difference in peak wavelengths between the two light-emitting elements can be 10 nm or less, allowing improvement in natural light similarity without increasing chromatic aberration.

To further improve Srms, the light emitter may include a wavelength converter containing at least two types of phosphors. These phosphors can include trace amounts of luminescent ions in the host materials, with the luminescent ions differing between the two phosphors. For example, to enhance the natural light similarity rms (Srms) in the green-yellow wavelength range (480 nm to 590 nm), the wavelength converter may include at least one type of green or yellow phosphor. Such phosphors can include YAG, LSN, LYSN, SiAlON, GYAG, LuAG, ZnZ, or Gd3Ga5O12, with Ce3+ as a possible luminescent ion. Additionally, to increase the intensity in the red region and improve Srms for the red light region, the wavelength converter may include at least one type of red phosphor. Examples of red phosphors include (Ca,Sr) AlSiN3+, La2O2S+, (La,Sr)AlO3, or CaAl2O4, with Eu2+ or Eu3+ used as luminescent ions.

Moreover, to further enhance Srms in the red region, two types of red phosphors with different peaks may be used. In this case, the difference in peak wavelengths between the two types of red phosphors can be 20 nm or more, increasing the intensities in both short-wavelength and long-wavelength red regions and improving Srms.

Moreover, to enhance Srms in the green-yellow region, two types of phosphors, one green and one yellow, can be used. These green and yellow phosphors may have peak differences of 10 nm or more, improving the intensities in the green and yellow regions and further enhancing Srms.

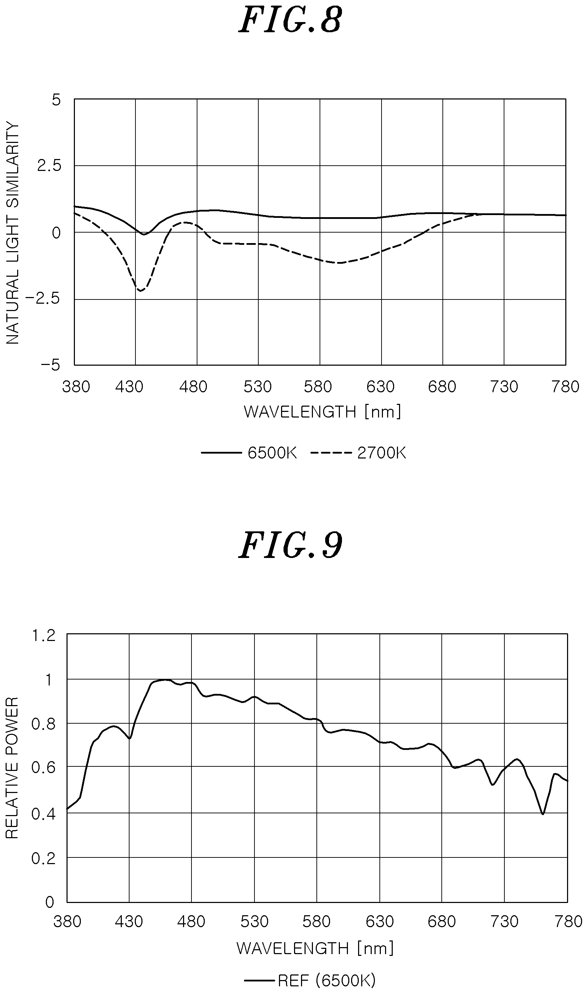

As shown in Figure 8, the natural light similarity of the light emitting device 1 and light emitter 400 may have different natural light similarity in each wavelength regions.

The similarity to natural light in the range of 430 nm to 470 nm may be relatively lower compared to other regions (excluding 430 nm to 470 nm). At this time, the natural light similarity may take a value between -2.5 and 1. Additionally, the natural light similarity in the range of 530 nm to 680 nm may be higher than in other regions (excluding 530 nm to 680 nm) and is preferably between -1.5 and 1. If the natural light similarity is higher in the long wavelength region of 530 nm to 680 nm than in the blue region, it may have a high color rendering index for red or yellow regions, thus implementing a high quality light emitting device. Moreover, if the light in the blue region from 430 nm to 470 nm is higher than that of natural light, the user may feel that it is bright even for similar light intensity, so it can be applied to security lights, etc.

Further, natural light similarity may vary with different correlated color temperatures. For example, the higher the correlated color temperature, the higher the natural light similarity. In other words, the lower the correlated color temperature, the lower the natural light similarity may be. For example, in the light emitter 400, if the first light emitting element 410 has a lower correlated color temperature than the second light emitting element 420, the natural light similarity of the first light emitting element 410 may have a lower natural light similarity than the second light emitting element 420. Alternatively, the light emitter 400 may have a natural light similarity equal to or higher than the first light emitting element 410 and a lower natural light similarity than the second light emitting element 420. More preferably, the natural light similarity between 430 nm and 730 nm may be such that the first light emitting element 410 has a lower correlated color temperature than the second light emitting element 420, and the natural light similarity between 430 nm and 730 nm of the light emitter 400 may have a natural light similarity higher than or equal to the first light emitting element 410 and may have a natural light similarity lower than or equal to the second light emitting element 420. On the other hand, when the first light emitting element 410 and the second light emitting element 420 are respectively in the first color temperature region S1 having a lower color temperature and the second color temperature region S2 having a higher color temperature, the natural light similarity Srms1 of the first light emitting element 410 may be higher than the natural light similarity Srms2 of the second light emitting element 420, as shown in Equation 3 below. The higher natural light similarity may have a lower Srms value.

$$\text{(Equation 3)}$$

$$Srms1 < Srms2$$

In Equation 3, Srms1 is the natural light similarity rms of the first light emitting element 410 and Srms2 is the natural light similarity rms of the second light emitting element 420.

The difference between the natural light similarity rms Srms1 of the first light emitting element 410 and the natural light similarity rms Srms2 of the second light emitting element 420 may be less than or equal to 0.2 as shown in the following Equation 4. This may ensure that the mixed light natural light similarity rms (Srms) value of the mixed light from the first light-emitting elements 410 and the second light-emitting elements 420 does not exceed 0.9, which may thereby reduce the design complexity of the light-emitting device 1.

$$\text{(Equation 4)}$$

$$|Srms1 - Srms2| \le 0.2$$

Further, the natural light similarity (Srms(sum)) of the mixed light of the first light emitting element 410 and the second light emitting element 420 may be lower than the natural light similarity of the first light emitting element 410 or the natural light similarity of the second light emitting element 420, as shown in Equations 5 and 6 below.

$$\text{(Equation 5)}$$

$$Srms1 > Srms(sum)$$

$$\text{(Equation 6)}$$

$$Srms2 > Srms(sum)$$

In Equations 5 and 6, Srms(sum) is the natural light similarity of the mixed light.

Further, a difference between the natural light similarity Srms(sum) of the mixed light and the natural light similarity of either the first light emitting element 410 or the second light emitting element 420 may be less than or equal to 0.2, as shown in the Equation 7 below. This may ensure that the mixed light natural light similarity rms (Srms) value of the mixed light from the first light-emitting elements 410 and the second light-emitting elements 420 does not exceed 0.9, which may thereby reduce the design complexity of the light-emitting device 1.

(Equation 7)

$$Srms1 - Srms(sum) \leq 0.2, \ Srms2 - Srms(sum) \leq 0.2$$

In particular, the lower the color temperature in the first light emitting element 410 and the second light emitting element 420 in the same color region, the higher the similarity to natural light. For example, in the first color temperature region S1, if the first light emitting element 410 is located to the left of the second light emitting element 420, it may have a lower natural light similarity. Further, when the first light emitting element 410 is in a lower region than the second light emitting element 420 in the first color temperature region S1, the first light emitting element 410 may have a lower natural light similarity compared to the second light emitting element 420. Further, the mixed light in which the light of the first light emitting element 410 is mixed with the light of the second light emitting element 420 may be located between the color coordinates of the first light emitting element 410 and the second light emitting element 420 in the first color temperature region S1, and the natural light similarity of the mixed light may have a value between the natural light similarities of the first light emitting element 410 and the second light emitting element 420.

Further, the natural light similarity for each wavelength may have a higher natural light similarity in the region of 510 nm to 630 nm, which is the sensitive region of human vision, and by increasing the natural light similarity in the sensitive region of human vision, the light emitting device with high color reproduction can be realized with minimal impact on light efficiency. In addition, the natural light similarity in the sensitive region may be higher for the light emitting element with lower color temperatures. Also, the higher the correlated color temperature, the lower the natural light similarity in the sensitive region may be. For example, in the light emitter light emitter 400, if the first light emitting element 410 has a higher correlated color temperature than the second light emitting element 420, the natural light similarity in the sensitive region of the first light emitting element 410 may have a lower natural light similarity in the sensitive region than the second light emitting element 420. Further, the light emitter 400 with mixed light may have the natural light similarity in the sensitive region equal to or higher than that of the first light emitting element 410 and lower than that of the second light emitting element 420.

Moreover, the natural light similarity in the sensitive region may not be proportional to the overall natural light similarity. For instance, the light emitting element with a higher correlated color temperature may have a higher overall natural light similarity than the light emitting element with a lower correlated color temperature, but the natural light similarity in the sensitive region may be higher in the light emitting element with the lower correlated color temperature. For example, in the light emitter 400, if the first light emitting element 410 has a higher correlated color temperature than the second light emitting element 420, the first light emitting element 410 may have a higher overall natural light similarity but a lower natural light similarity in the sensitive region compared to the second light emitting element 420. This is because the light emitting element with the relatively higher correlated color temperature requires less light in the long wavelength region than the light emitting device with the lower correlated color temperature, so long wavelength conversion can be done only as needed, thereby improving luminous efficiency

Further, the standard deviation of the natural light similarity $S(x_k)$ for each wavelength may be higher for the first light emitting element 410 than for the second light emitting element 420. The standard deviation of the natural light similarity for the light emitter 400 may have a value between that of the first light emitting element 410 and the second light emitting element 420, and may be equal to or lower than the first light emitting element 410 and equal to or higher than the second light emitting element 420.

Further, the Srms value may be lower for the first light emitting element 410 than the second light emitting element 420 in the light emitter 400 when the first light emitting element 410 has a lower correlated color temperature than the second light emitting element 420. In other words, the second light emitting element 420 may have a higher Srms value than the first light emitting element 410 and may have a light intensity for each wavelength similar to natural light. Further, the Srms value of the light emitter 400 may have a Srms value between the first light emitting element 410 and the second light emitting element 420, and more preferably may have a higher Srms value than the first light emitting element 410 and a lower Srms value than the second light emitting element 420.

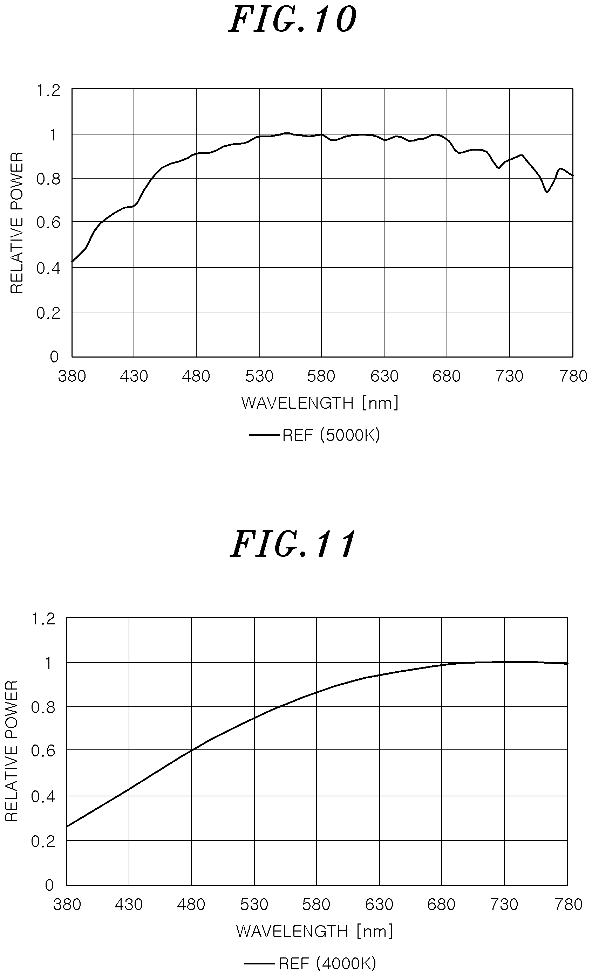

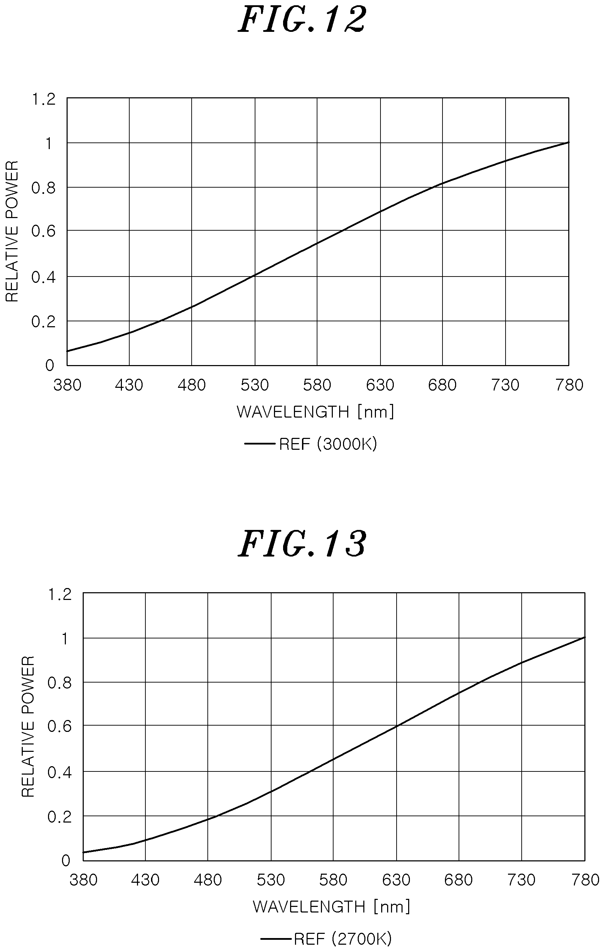

Figs. 9 to 13 illustrate the relative spectral flux of natural light for each wavelength. Referring to Fig. 9, the relative spectral flux of natural light at a correlated color temperature of 6500K may be the highest in the range of 440 nm to 480 nm. In other words, the relative spectral flux at 460 nm may peak at 1. Referring to Fig. 10, the relative spectral flux of natural light at a correlated color temperature of 5000K may be the highest between 530 nm and 680 nm. In other words, the relative spectral flux at 550 nm may peak at 1. Referring to Fig. 11, the relative spectral flux of natural light for each wavelength at a correlated color temperature of 4000K may be the highest in the range of 700 nm to 750 nm. In other words, the relative spectral flux at 733 nm may peak at 1. Referring to Fig. 12, the relative spectral flux of natural light at a correlated color temperature of 3000K may be the highest in the range of 750 nm to 780 nm. In other words, the relative spectral flux at 780 nm may peak at 1. Referring to Fig. 13, the relative spectral flux of natural light for each wavelength at a correlated color temperature of 2700K may be the highest in the range of 750 nm to 780 nm. In other words, the relative spectral flux may have a peak at 780 nm with a value of 1. As the spectrum of natural light decreases, the wavelength at which the maximum relative spectral flux is formed may increase.

The controller 600 may control the light emitter 400 so that light is emitted from the light emitter 400. The controller 600 may also control the light emitter 400 to emit light that satisfies the Srms value defined in Equation 1 ranging from 0.001 to 0.9. This may be used to generate light similar to sunlight. Furthermore, the controller 600 may control the light emitter 400 based on input data received from a terminal. The input data may include one or more of color coordinates, color temperature, location information, weather information, input time value, input date value, and one or more instructions for controlling the light emitting device 1. The input data may be entered by a user operating the terminal.

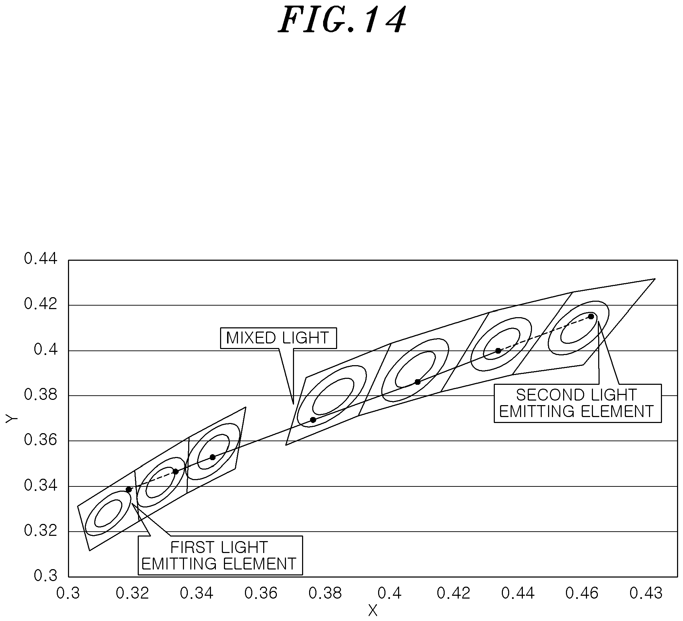

Referring to Fig. 14, there is an example of a color coordinate shift of mixed light of the first light emitting element 410 and the second light emitting element 420 when the second light emitting element 420 has a lower color temperature than the first light emitting element 410.

The controller 600 may adjust the driving ratio of the first light emitting element 410 and the second light emitting element 420 to form mixed light between the first light emitting element 410 and the second light emitting element 420. In this case, the natural light similarity of the mixed light may fall between the natural light similarities of the first light emitting element 410 and the second light emitting element 420. For example, when the Srms value of the first light emitting element 410 is 0.9 and that of the second light emitting element 420 is 0.5, the controller 600 can adjust the driving ratios of the first light-emitting element 410 and the second light-emitting element 420 so that the Srms value of the mixed light's similarity to natural light becomes lower than the lowest Srms value of 0.9. In other words, the controller 600 can adjust the driving ratios of multiple light emitting elements to ensure that the mixed light achieves an Srms value lower than the largest Srms value among the light emitting elements with the lowest similarity to natural light. Through this process, a light-emitting device 1 capable of emitting light similar to natural light can be realized. The mixed light may have an x value larger than that of the first light emitting element 410 and lower than that of the second light emitting element 420. Additionally, the mixed light may have a y value larger than that of the first light emitting element 410 and lower than that of the second light emitting element 420.

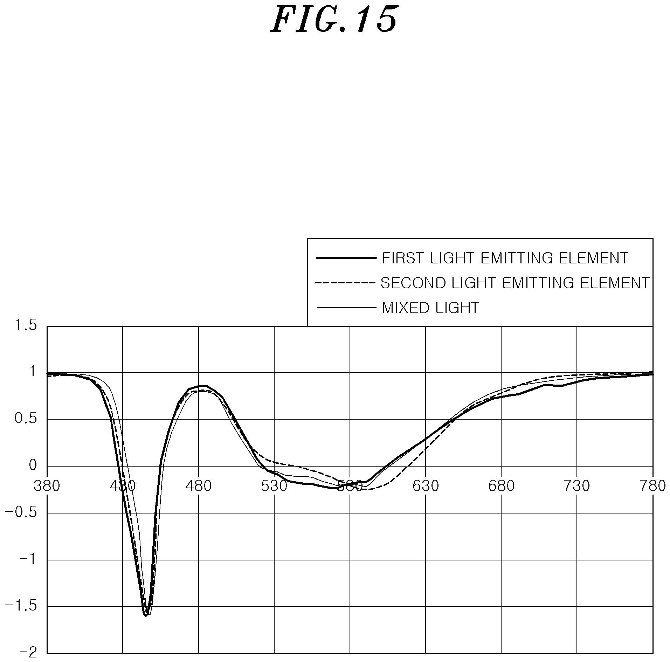

Referring to Fig. 15, there is an example of the natural light similarities of the first light emitting element 410 with a high color temperature, the second light emitting element 420 with a low color temperature, and the mixed light of the two. The first light emitting element 410 may have a color temperature of 6500K. The second light emitting element 420 may have a color temperature of 2700K. The mixed light may have a color temperature between 2700K and 6500K. The first light emitting element 410 may have a lower natural light similarity than the second light emitting element 420. The second light emitting element 420 with a lower color temperature may have a higher natural light similarity than the first light emitting element 410 which has a higher natural light similarity in the sensitive region between 510 nm and 630 nm. Furthermore, the natural light similarity of the mixed light for each wavelength in the sensitivity region may fall between the natural light similarities of the first light emitting element 410 and the second light emitting element 420. In one wavelength region, the natural light similarity of the mixed light may be higher than that of the first light emitting element 410 and lower than that of the second light emitting element 420. In one wavelength region, the natural light similarity of the mixed light may be lower than that of the first light emitting element 410 and higher than that of the second light emitting element 420. Since the natural light similarity of the mixed light in the sensitivity region of 510 nm to 630 nm may be higher than that of both the first light emitting element 410 and the second light emitting element 420, it is possible to enhance the natural light similarity without increasing the amount of phosphor used by utilizing two or more light emitting elements, thereby reducing production complexity.

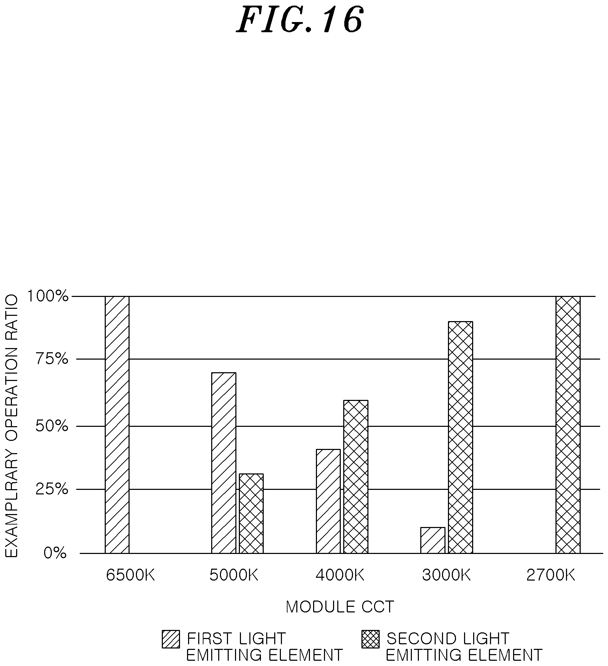

Further, referring further to Fig. 16, the controller 600 may control the light intensity of the first light emitting element 410 and the second light emitting element 420 based on time-light intensity correlation information. The controller 600 may also store light intensity data for adjusting the light intensity of the first light emitting element 410 and the second light emitting element 420. The light intensity data may include a first adjustment value for determining the intensity of the first light emitting element 410 and a second adjustment value for determining the intensity of the second light emitting element 420. The first adjustment value may be a power applied to the first light emitting element 410 to cause the first light emitting element 410 to emit light. The second adjustment value may be a power applied to the second light emitting element 420 to cause the second light emitting element 420 to emit light. The controller 600 may control the power distributor 500 based on the first adjustment value and the second adjustment value. In other words, the controller 600 may control the power distributor 500 such that the first adjustment value is applied to the first light emitting element 410 and the second adjustment value is applied to the second light emitting element 420.

Table 1 is an exemplary table of the correlation information between the first and second control values based on color temperature.

(Table 1)

| color | | Light Source | | Remark |
|---|---|---|---|---|
| | | 1 | 2 | |
| | | Warm | Cool | |
| Module | Noon (Reference) | 0% | 100% | cool white |
| | ▼ | 30% | 70% | |
| | Daylight | 60% | 40% | Neutral white |
| | ▼ | 90% | 10% | |
| | Sunset (Start)/Sunrise (End) | 100% | 0% | Warm white |

Referring to Table 1, when the first light emitting device has a low color temperature and the second light emitting device has a high color temperature, the first adjustment value applied to the first light emitting device may be decreased and the second adjustment value applied to the second light emitting device may be increased as the color temperature increases. In other words, as the color temperature increases, the intensity of the light of the second light emitting element 420 increases, so that the proportion of the light of the second light emitting element 420 in the light of the light emitter 400 increases, and the proportion of the light of the first light emitting element 410 decreases, and the correlated color temperature of the light emitter 400 may have a correlated color temperature closer to the second light emitting element 420 than to the first light emitting element 410, and may have a higher color temperature than the first light emitting element 410. Further, as the color temperature decreases, the second adjustment value may decrease and the first adjustment value may increase. In other words, as the color temperature decreases, the intensity of the light of the first light emitting element 410 increases, so that the proportion of the light of the second light emitting element 420 in the light of the light emitter 400 decreases, and the proportion of the light of the first light emitting element 410 increases, and the correlated color temperature of the light emitter 400 may have a correlated color temperature closer to the first light emitting element 410 than the second light emitting element 420, and may have a correlated color temperature lower than the second light emitting element 420.

The light emitting device 1 can generate light with a correlated color temperature similar to that of natural light, and can emit light whose spectrum of the light flux for each wavelength similar to that of natural light with the same correlated color temperature. In other words, the light flux for each wavelength emitted by the light emitting device 1 can be formed to satisfy the Srms value between 0.001 and 1, as expressed in Equation 1. Preferably, the Srms value may be between 0.05 and 0.9 to have a significant effect on human visual sensitivity.

For example, when the light emitter 400 emits light with a correlated color temperature of 6500K, the Srms value can be formed between 0.05 and 0.70. When the light emitter 400 emits light with a correlated color temperature of 4000K, the Srms value can also be between 0.05 and 0.70. When the light emitter 400 emits light with a correlated color temperature of 2700K, the Srms value can be formed between 0.40 and 0.75.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

(Explanation of Symbols)

| | | | |
|---|---|---|---|
| 1: | light emitting device | 2: | terminal |
| 100: | housing | 200: | heat sink |
| 300: | cover | 400: | light emitter |
| 410: | first light emitting element | 420: | second light emitting element |

(continued)

| 500: | power distributor | 600: | controller |
|------|-------------------|------|------------|
| 700: | microphone | | |

## Claims

1. A light emitting device comprising:

   a plurality of light emitting elements that emit light within a predetermined color temperature region on a color coordinate system,
   wherein an average of color coordinate values of the plurality of light emitting elements are located within the predetermined color temperature region,
   the plurality of light emitting elements include a first light emitting element and a second light emitting element that satisfy a following Equation 1:

   $$\text{(Equation 1)}$$

   $$Srms = \sqrt{\frac{1}{(b-a)} \sum_{k=a}^{b} \left(1 - \frac{L_c(x_k)}{ref_c(x_k)}\right)^2} < 0.9$$

   where, in the Equation 1, the "a" is a wavelength selected from a range of 200 nm or more and less than 500 nm, the "b" is a wavelength selected from a range of 500 nm or more and less than 900 nm, the "$L_C(x_k)$" is a normalized spectral radiant flux of a light emitted from the plurality of light emitting elements, and the "$ref_c(x_k)$" is a normalized spectral radiant flux of a natural light normalized from a natural light spectrum.

2. The light emitting device of claim 1, wherein the color temperature region has four vertices defined by a first coordinate, a second coordinate, a third coordinate, and a fourth coordinate on the color coordinate system,

   wherein the first coordinate has an x-value smaller than x-values of the second coordinate and the third coordinate, and a y-value smaller than y-values of the second coordinate, the third coordinate, and the fourth coordinate,
   wherein the second coordinate has a y-value smaller than the y-values of the third coordinate and the fourth coordinate,
   wherein the third coordinate has a y-value greater than the y-values of the first coordinate, the second coordinate, and the fourth coordinate, and an x-value greater than the first coordinate and the fourth coordinate, and
   wherein the fourth coordinate has a y-value greater than the y-values of the first coordinate and the second coordinate and smaller than the y-value of the third coordinate, and an x-value smaller than the x-values of the second coordinate and the third coordinate.

3. The light emitting device of claim 1, wherein the color temperature region has an elliptical shape on the color coordinate system.

4. The light emitting device of claim 3, wherein the color temperature region is inclined at a predetermined angle with respect to an x-axis on the color coordinate system.

5. The light emitting device of claim 4, wherein the predetermined angle ranges from 40° to 70°.

6. The light emitting device of claim 3, wherein a length of a major axis of the color temperature region ranges from 0.0110 to 0.0144.

7. The light emitting device of claim 4, wherein a length of the minor axis of the color temperature region ranges from 0.0045 to 0.0066.

8. The light emitting device of claim 1, wherein the color temperature of the light emitted by the plurality of light emitting elements ranges from 1700K to 7000K.

9. A light emitting device comprising:

a plurality of first light emitting elements that emit light in a first color temperature region on a color coordinate system among a plurality of color temperature regions;
a plurality of second light emitting elements that emit light in a second color temperature region, different from the first color temperature region, on the color coordinate system; and
a controller that controls an intensity of light emitted from the plurality of light emitting elements such that an average of color coordinate values of the plurality of first light emitting elements and the second light emitting elements are positioned within one of the plurality of color temperature regions,
wherein the controller controls the plurality of first light emitting element and the second light emitting element to satisfy a following equation 1:

(Equation 1)

$$Srms = \sqrt{\frac{1}{(b-a)} \sum_{k=a}^{b} \left(1 - \frac{L_c(x_k)}{ref_C(x_k)}\right)^2} < 0.9$$

where, in the Equation 1, the "a" is a wavelength selected from a range of 200 nm or more and less than 500 nm, the "b" is a wavelength selected from a range of 500 nm or more and less than 900 nm, the "$L_C(x_k)$" is a normalized spectral radiant flux of a light emitted from the plurality of light emitting elements, and the "$ref_c(x_k)$" is a normalized spectral radiant flux of a natural light normalized from a natural light spectrum.

10. The light emitting device of claim 9, wherein the first color temperature region has the largest central color coordinate x- and y-values among the plurality of color temperature regions, and the second color temperature region has the smallest central color coordinate x- and y-values among the plurality of color temperature regions, and
wherein the controller controls the intensity of light emitted from the plurality of first light emitting elements and the intensity of light emitted from the second light emitting elements such that the average of the color coordinate values of the plurality of light emitting elements moves from one of the first color temperature region and the second color temperature region toward the other of the first color temperature region and the second color temperature region.

11. The light emitting device of claim 10, wherein the controller increases the intensity of light emitted from the plurality of first light emitting elements and decreases the intensity of light emitted from the plurality of second light emitting elements so that the average of the color coordinate values of the plurality of light emitting elements to move towards the first color temperature region.

12. The light emitting device of claim 10, wherein the controller decreases the intensity of light emitted from the plurality of first light emitting elements and increases the intensity of light emitted from the plurality of second light emitting elements so that the average of the color coordinate values of the plurality of light emitting elements to move towards the second color temperature region.

13. The light emitting device of claim 10, wherein the controller controls the intensity of light emitted from the plurality of first light emitting elements and the intensity of light emitted from the plurality of second light emitting elements to be equal so that the average of the color coordinate values of the plurality of light emitting elements is disposed in a center of the first color temperature region and the second color temperature region while being disposed within one of the plurality of color temperature regions.

14. The light emitting device of claim 9, wherein the plurality of color temperature regions have rectangular shapes on the color coordinate system and at least some of which are in contact with each other.

15. The light emitting device of claim 13, wherein a size of the first color temperature region is larger than a size of the second color temperature region.

# FIG.1

# FIG.2

# FIG.3

# FIG.4

# FIG.5

# FIG.6

# FIG.7

# FIG.8

# FIG.9

# FIG.10

REF (5000K)

# FIG.11

REF (4000K)

## FIG.12

*REF (3000K)*

## FIG.13

*REF (2700K)*

# *FIG.14*

# FIG.15

# FIG.16